# EUROPÄISCHE PATENTSCHRIFT

(11) **EP 2 178 206 B1**
(45) Veröffentlichungstag und Bekanntmachung des Hinweises auf die Patenterteilung: **22.04.2015**
(21) Anmeldenummer: 09013052.7
(22) Anmeldetag: 15.10.2009
(51) Int. Cl.: H03F 1/32

(54) **Feed-forward-Verstärker mit Vorrichtung zum Erzeugen eines Korrektursignals**
Feed-forward amplifier with device for creating a correction signal
Amplificateur à correction aval avec dispositif de production d'un signal de correction

(30) Priorität: 17.10.2008 DE 102008052172
(43) Veröffentlichungstag der Anmeldung: 21.04.2010
(73) Patentinhaber: Fraunhofer-Gesellschaft zur Förderung der angewandten Forschung e.V., 80686 München (DE)
(72) Erfinder: Laske, Christopher, 91052 Erlangen (DE); Ulbricht, Gerald, 91227 Leinburg (DE)
(74) Vertreter: Zimmermann, Tankred Klaus

(56) Entgegenhaltungen:
- EP-A1- 1 152 524
- US-A1- 2002 084 847
- US-A1- 2002 141 509

## Beschreibung

Ausführungsbeispiele gemäß der Erfindung beziehen sich auf eine Vorrichtung zum Erzeugen eines Korrektursignals zum Linearisieren eines Ausgangssignals eines nicht-linearen Elements und ein Verfahren zum Erzeugen eines Korrektursignals zum Linearisieren eines Ausgangssignals eines nicht-linearen Elements.

Einige Ausführungsbeispiele gemäß der Erfindung beziehen sich auf ein Verfahren zur Linearisierung mit digitaler Signalverarbeitung nach dem Feedforward-Prinzip (Vorwärtskopplungs-Prinzip).

Durch eine Linearisierung von beispielsweise Verstärkern können im Verstärker erzeugte unerwünschte Signalanteile verringert werden.

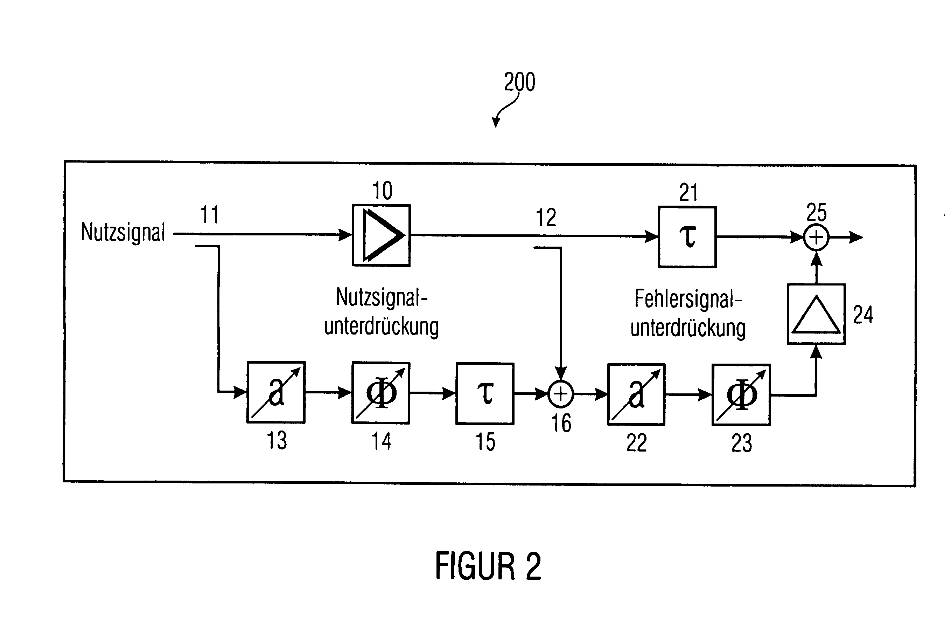

Das Feedforward-Verfahren (Vorwärtskopplungs-Verfahren) zur Linearisierung von beispielsweise Verstärkern ist schon länger bekannt und wird vielfach eingesetzt. Fig. 2 zeigt dazu ein Blockschaltbild einer bekannten Vorrichtung 200 zum Linearisieren eines Verstärkers nach dem Feedforward-Prinzip.

Die Komponente 10, die linearisiert werden soll, beispielsweise ein Verstärker, wird mit einem Eingangssignal, im weiteren auch Nutzsignal genannt, beaufschlagt. Vor dieser Komponente 10 wird ein Teil des Signals ausgekoppelt (wie bei Bezugszeichen 11 gezeigt), das als Referenzsignal für eine Nutzsignalunterdrückung dient. Nach der Komponente 10 wird ebenfalls ein Teil des Signals ausgekoppelt (wie bei Bezugszeichen 12 gezeigt), das im Weiteren als Ausgangssignal oder als ein Teil des Ausgangssignals bezeichnet wird, das nicht nur das Nutzsignal enthält, sondern auch die in der Komponente 10 unerwünschten Anteile, das sogenannte Fehlersignal.

Das Referenzsignal wird in Amplitude (wie bei Bezugszeichen 13 gezeigt) und Phase (wie bei Bezugszeichen 14 gezeigt) so abgeglichen, dass es am Summationspunkt 16, beispielsweise einem Koppler, die gleiche Amplitude und 180-Grad Phasenversatz besitzt wie der Teil des Ausgangssignals, der ausgekoppelt wurde. Dafür ist auch eine Verzögerung 15 notwendig, die die Laufzeit von Komponente 10 ausgleicht.

Im Summierer 16, auch Kombinierer genannt, wird wegen dem 180-Grad Phasenversatz der Nutzsignalanteil unterdrückt. Das Fehlersignal bleibt erhalten, da es nur in einem der beiden aufsummierten Signale enthalten ist.

Die Amplitude (wie bei Bezugszeichen 22 gezeigt) und die Phase (über Bezugszeichen 23 gezeigt) des Fehlersignals werden so abgeglichen, dass es am Summationspunkt 25, beispielsweise einem Richtkoppler, gleiche Amplitude und 180 Grad Phasenversatz besitzt wie das Fehlersignal, das auf direktem Pfad von der Komponente 10 über einen Verzögerer 21 zum Summationspunkt gelangt. Dafür ist ein Hilfsverstärker 24 notwendig, der beispielsweise die Verluste vom Koppler 12 und Summierer 25 ausgleicht, sowie eine Verzögerung 21 im Direktpfad, die die Laufzeit des Hilfsverstärkers ausgleicht.

Wegen dem 180 Grad Phasenversatz wird der Fehlersignal-Anteil im Ausgangssignal unterdrückt. Das Nutzsignal bleibt erhalten, da es nur in einem der beiden aufsummierten Pfade enthalten ist.

Die Funktionsweise des Feedforward-Verfahrens hängt in hohem Maße davon ab, wie gut die Amplitude und die Phase der summierten Signale abgeglichen werden können. Je genauer Amplitude und Phase bei der Summation übereinstimmen, desto besser wird der unerwünschte Signalanteil unterdrückt, und desto besser arbeitet das gesamte System.

Entscheidend ist außerdem, dass im Referenzpfad der Nutzsignalunterdrückung (wie bei Bezugszeichen 13, 14 und 15 gezeigt) keine zusätzlichen Störsignale erzeugt werden, beispielsweise durch nicht-lineare Bauteile in einem Phasensteller 14. Diese Störsignale werden nicht unterdrückt und erscheinen am Ausgang des Feedforward-Systems zusätzlich zum Nutzsignal.

Zum Abgleich der Schleifen ist beispielsweise ein Phasensteller notwendig, mit dem die Phase des Signals möglichst genau eingestellt werden kann. Dies kann z.B. durch analoge Phasensteller erfolgen.

Eine Möglichkeit sind Phasensteller mit nicht-linearen Bauteilen, wie z.B. Mischer. In nicht-linearen Bauteilen entstehen jedoch harmonische und Intermodulationen, die von dem Feedforward-System nicht mehr entfernt werden können.

Eine andere Möglichkeit sind Vektor-Phasenschieber aus rein passiven Bauelementen. Vektor-Phasenschieber aus rein passiven Bauelementen erzeugen ein Quadratursignal mit Hilfe eines passiven 90-Grad Splitters (90-Grad Teiler). Der Nachteil dabei ist, dass ein 90-Grad Splitter eine nicht konstante Gruppenlaufzeit besitzt, die für einen Einsatz in einem Feedforward-System entzerrt werden muss.

Deshalb ist eine Realisierung eines Feedforward-Systems zu einem großen Teil im Digitalen wünschenswert. Damit kann es möglich sein, z.B. Phasensteller im Digitalen zu implementieren. Digitale Phasensteller können sehr genau und mit konstanter Gruppenlaufzeit implementiert werden. Damit kann der Abgleich der Schleifen genauer erfolgen als im Analogen, und die Unterdrückung der unerwünschten Signalanteile kann entsprechend verbessert werden.

Nachteile von analogen Phasenstellern können vermieden werden.

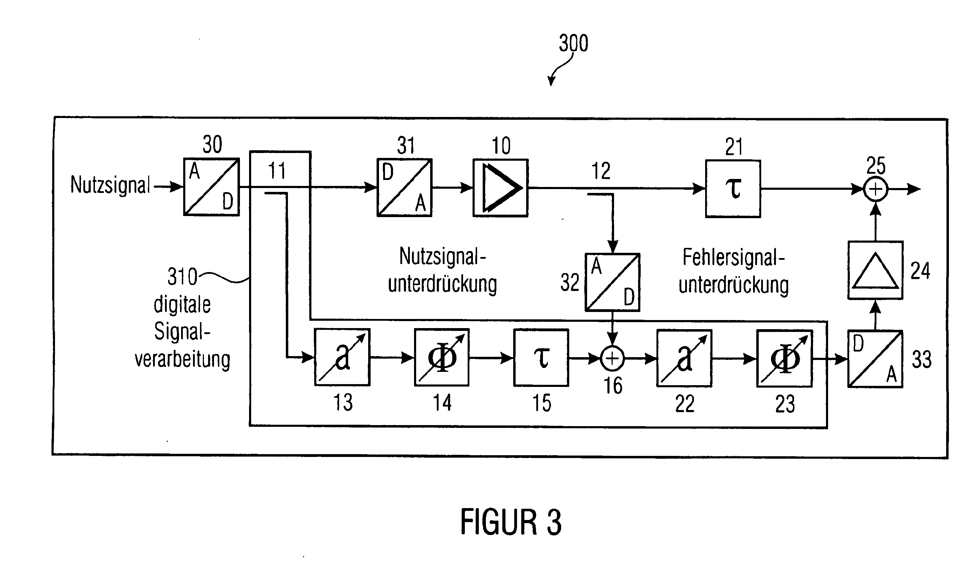

Fig. 3 zeigt dazu ein Blockschaltbild einer bekannten Vorrichtung 300 zum Linearisieren eines Verstärkers nach dem Feedforward-Prinzip. Das Nutzsignal oder Eingangssignal wird mit einem Analog-Digital-Umsetzer 30 digitalisiert. Nach dem Auskoppeln des Referenzsignals für die Nutzsignal-Unterdrückung (wie bei Bezugszeichen 11 gezeigt) im Digitalen wird das Signal (Eingangssignal) mit einem Digital-Analog-Umsetzer 31 wieder ins Analoge umgesetzt und der Komponente 10 zugeführt.

Der Aufbau entspricht dabei im Prinzip der in Fig. 2 gezeigten Vorrichtung.

Das Ausgangssignal von Komponente 10 wird im Analogen ausgekoppelt (wie bei Bezugszeichen 12 gezeigt) und dann mit einem Analog-Digital-Umsetzer 32 digitalisiert. Damit kann die Summation 16 für die Nutzsignal-Unterdrückung im Digitalen erfolgen, und die Komponenten für den Abgleich der Amplitude 13 und der Phase 14, sowie die Signalverzögerung 15 können im Digitalen als Teil der digitalen Signalverarbeitung realisiert werden.

Auch der Abgleich der Fehlersignal-Unterdrückung für Amplitude (wie bei Bezugszeichen 22 gezeigt) und Phase (wie bei Bezugszeichen 23 gezeigt) erfolgt im Digitalen. Vor der Verstärkung durch den Hilfsverstärker 24 muss das Signal mit einem Digital-Analog-Umsetzer 33 wieder ins Analoge umgesetzt werden. Die Summation für die Fehlersignal-Unterdrückung geschieht im Analogen.

Dabei spielt beispielsweise die Qualität der Analog-Digital-Umsetzer und der Digital-Analog-Umsetzer eine wichtige Rolle.

Des Weiteren ist in Fig. 3 der Bereich 310 der digitalen Signalverarbeitung markiert.

Bekannte Beispiele dazu sind auch in "Building blocks for wideband powerbank for shipboard HF communication systems, Laske, C.; Ulbricht, G.; Heuberger, A., London: IET, 2006, ISBN: 0863416594, ISBN: 9780863416590, pp. 105-109" gezeigt.

Weitere bekannte Beispiele sind in den Patentschriften US 4389618, US 4560945, US 45916407, US 4926134, US 4926136, EP 0411180, US 5157345, US 5077532, US 5148117, US 5300894, US 544864, US 5455537, US 5489875, US 5789976, WO 98/04034, US 5760646, US 5862459, US 5774018, US 5898338, WO 98/12800, US 5877653, US 6067448, US 5994957, US 6075411, US 5959500, US 6078216, EP 0869606, US 6531918, US 6166601, EP 0996222, US 6583739/WO 01/08293, US 6392481, WO 01/41297, US 6266517, US 2003/0132802, EP 1124324A1, US 6275106, US 6359508, EP 1353438, EP 1241781A1. US 6504428, US 6496064, US 2003/0030490, US 6407635, US 6683495, EP 1309082, US 2003/0174017, WO03/105337, US 2004/0004516 und US 2003/0184373 gezeigt.

Die US 2002/084847 A1 beschreibt einen digitalen Linearisierer bei dem gemäß einem digitalen Linearisierungsverfahren ein digitales Eingangssignal auf einem ersten Pfad mit einem Ausgangssignal einer Hauptverstärkereinheit betrieben wird, um so die in dem Ausgangssignal der Hauptverstärkereinheit enthaltenen Störungskomponenten zu erfassen. Ein digitales Eingangssignal auf einem zweiten Pfad wird mit den detektierten Störungskomponenten korreliert, um so adaptiv eine Verstärkung des digitalen Eingangssignals auf dem zweiten Pfad während der Detektion der Störungskomponenten zu steuern.

Die Aufgabe der vorliegenden Erfindung ist es, eine verbesserte Vorrichtung zum Erzeugen eines Korrektursignals zu schaffen, um die Anforderungen an zumindest einen Teil der verwendeten digitalen Komponenten reduzieren zu können.

Diese Aufgabe wird durch eine Vorrichtung gemäß Anspruch 1 und ein durch Verfahren gemäß Anspruch 13 und 14 gelöst.

Ein Ausführungsbeispiel gemäß der Erfindung schafft eine Vorrichtung zum Erzeugen eines Korrektursignals zum Linearisieren eines Ausgangssignals eines nicht-linearen Elements, die einen Korrektursignalerzeuger aufweist. Der Korrektursignalerzeuger ist ausgelegt, um basierend auf einer Überlagerung eines digitalen Referenzsignals und eines überlagerten Ausgangssignals ein Korrektursignal zu erzeugen. Das überlagerte Ausgangssignal basiert dabei auf einer Überlagerung des Ausgangssignals mit einem analogen Referenzsignal. Das analoge Referenzsignal und das digitale Referenzsignal werden basierend auf einem Eingangssignal des nicht-linearen Elements erzeugt. Das nicht-lineare Element ist dabei ausgelegt, um das Ausgangssignal basierend auf dem Eingangssignal zu erzeugen.

Ausführungsbeispiele gemäß der Erfindung basieren auf dem Kerngedanken, dass durch die Überlagerung des analogen Referenzsignals mit dem Ausgangssignal des nicht-linearen Elements eine analoge Vorunterdrückung durchgeführt wird. Erst danach erfolgt eine Überlagerung mit dem digitalen Referenzsignal, wobei im digitalen Signalverarbeitungsbereich das überlagerte Ausgangssignal und das digitale Referenzsignal sehr genau aneinander angepasst werden können, wodurch ein qualitativ hochwertiges Korrektursignal erzeugt werden kann. Durch die analoge Vorunterdrückung können Anforderungen an zumindest einen Teil der Komponenten der digitalen Signalverarbeitung reduziert werden. Dadurch können beispielsweise die Kosten gesenkt und die Qualität des Korrektursignals erhöht werden.

Einige Ausführungsbeispiele gemäß der Erfindung schaffen ein Verfahren zum Erzeugen eines Korrektursignals zum Linearisieren eines Ausgangssignals eines nicht-linearen Elements. Das Verfahren umfasst dabei ein Überlagern eines analogen Referenzsignals und des Ausgangssignals, um ein überlagertes Ausgangssignal zu erhalten, und ein Überlagern eines digitalen Referenzsignals mit dem überlagerten Ausgangssignal, um das Korrektursignal zu erzeugen. Das analoge Referenzsignal und das digitale Referenzsignal werden basierend auf einem Eingangssignal des nicht-linearen Elements erzeugt. Das nicht-lineare Element ist dabei ausgelegt, um das Ausgangssignal basierend auf dem Eingangssignal zu erzeugen.

Ausführungsbeispiele gemäß der Erfindung werden nachfolgend Bezug nehmend auf die beiliegenden Figuren näher erläutert. Es zeigen:
- Fig. 1: eine schematische Darstellung einer Vorrichtung zum Erzeugen eines Korrektursignals;
- Fig. 2: ein Blockschaltbild einer bekannten Vorrichtung zum Linearisieren eines Verstärkers nach dem Feedforward-Prinzip;
- Fig. 3: ein Blockschaltbild einer bekannten Vorrichtung zum Linearisieren eines Verstärkers nach dem Feedforward-Prinzip;
- Fig. 4: ein Blockschaltbild einer Vorrichtung zum Linearisieren eines Ausgangssignals eines nicht-linearen Elements;
- Fig. 5: ein Blockschaltbild einer weiteren Vorrichtung zum Linearisieren eines Ausgangssignals eines nicht-linearen Elements; und
- Fig. 6: ein Flussdiagramm eines Verfahrens zum Erzeugen eines Korrektursignals zum Linearisieren eines Ausgangssignals eines nicht-linearen Elements.

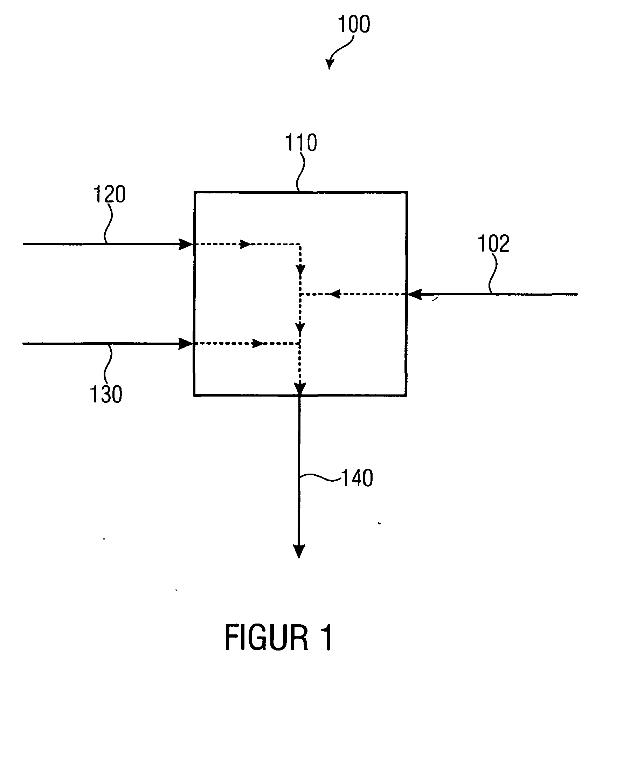

Fig. 1 zeigt eine Vorrichtung 100 zum Erzeugen eines Korrektursignals 140 zum Linearisieren eines Ausgangssignals 102 eines nicht-linearen Elements entsprechend einem Ausführungsbeispiel gemäß der Erfindung. Die Vorrichtung 100 umfasst dabei einen Korrektursignalerzeuger 110, wobei der Korrektursignalerzeuger 110 ausgelegt ist, um basierend auf einer Überlagerung eines digitalen Referenzsignals 130 und eines überlagerten Ausgangssignals ein Korrektursignal 140 zu erzeugen. Das überlagerte Ausgangssignal basiert dabei auf einer Überlagerung des Ausgangssignals 102 mit einem analogen Referenzsignal 120.

Das analoge Referenzsignal 120 wird mit dem Ausgangssignal 102 überlagert, um eine analoge Vorunterdrückung zu realisieren. Dabei kann das analoge Referenzsignal 120 beispielsweise von einem Eingangssignal des nicht-linearen Elements abgleitet werden. Durch die analoge Vorunterdrückung in Form der Überlagerung können die Eingangssignalanteile im Ausgangssignal 102 zumindest teilweise unterdrückt werden. Dadurch kann eine Weiterverarbeitung des überlagerten Ausgangssignals im digitalen Teil des Korrektursignalerzeugers 110 erleichtert werden.

So kann beispielsweise eine begrenzte Dynamik eines Analog-Digital-Umsetzers, der zum Beispiel zur Digitalisierung des (überlagerten) Ausgangssignals des nicht-linearen Elements eingesetzt werden kann, besser ausgenutzt werden, wenn eine analoge Vorunterdrückung eingesetzt wird.

Das analoge Referenzsignal 120 und das digitale Referenzsignal 130 können beispielsweise basierend auf dem Eingangssignal des nicht-linearen Elements erzeugt werden. Dazu kann z.B. ein Teil des Eingangssignals ausgekoppelt werden. Alternativ kann das analoge Referenzsignal 120 basierend auf dem digitalen Referenzsignal 130 erzeugt werden oder das digitale Referenzsignal 130 basierend auf dem analogen Referenzsignal 120 erzeugt werden.

Der Korrektursignalerzeuger 110 kann, wie in Fig. 1 gezeigt, das digitale Referenzsignal 130 und das analoge Referenzsignal 120 als Eingangssignal bereitgestellt bekommen, oder der Korrektursignalerzeuger 110 kann beispielsweise ausgelegt sein, um das digitale Referenzsignal 130 und/oder das analoge Referenzsignal 120, basierend auf z.B. dem Eingangssignal des nicht-linearen Elements, zu erzeugen.

Der Korrektursignalerzeuger 110 kann beispielsweise einen Analog-Digital-Umsetzer aufweisen, der ausgelegt ist, um das überlagerte Ausgangssignal nach der analogen Vorunterdrückung in ein digitales Signal umzuwandeln.

Des Weiteren kann der Korrektursignalerzeuger 110 Elemente zum Anpassen der Amplitude, der Phase und der Signallaufzeit der verschiedenen Signale aufweisen. Dadurch kann wiederum entsprechend dem Feedforward-Prinzip 180-Grad Phasenversatz zwischen dem analogen Referenzsignal 120 und dem Ausgangssignal 102 sowie dem digitalen Referenzsignal 130 und dem überlagerten Ausgangssignal erzeugt werden.

Das Korrektursignal 140 kann verwendet werden, um das Ausgangssignal 102 des nicht-linearen Elements zu linearisieren. Unter dem Linearisieren eines Ausgangssignals versteht man beispielsweise, dass das linearisierte Ausgangssignal eine linearere Charakteristik aufweist als das ursprüngliche Ausgangssignal. Unerwünschte Signalanteile können zumindest teilweise unterdrückt werden.

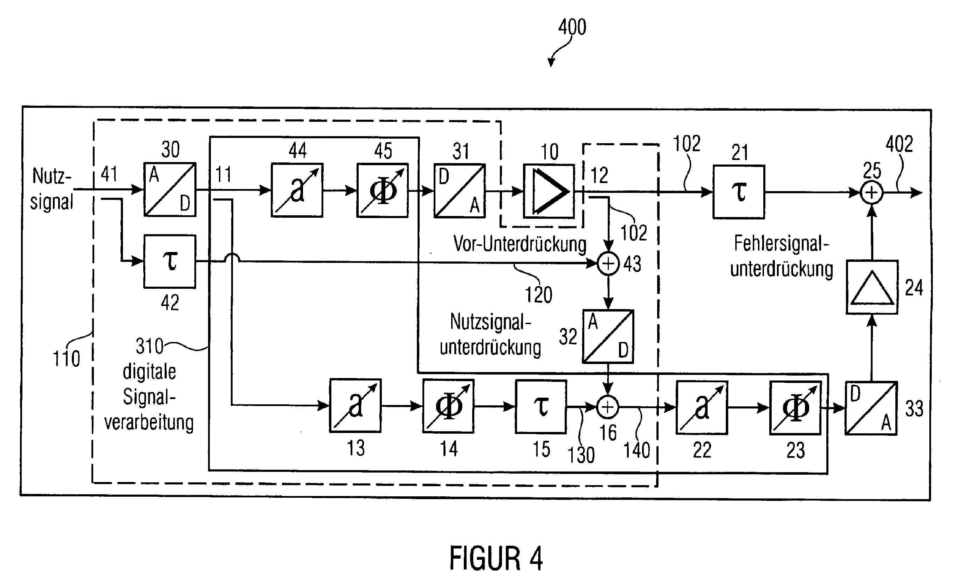

Fig. 4 zeigt ein Blockschaltbild einer Vorrichtung 400 zum Linearisieren eines Ausgangssignals 102 eines nicht-linearen Elements 10 entsprechend einem Ausführungsbeispiel gemäß der Erfindung. Die Vorrichtung 400 umfasst einen Korrektursignalerzeuger 110, Elemente zum Anpassen des Korrektursignals 140 an das Ausgangssignal 102, einen Verzögerer 21 zum Anpassen einer Signallaufzeit des Ausgangssignals 102 an eine Signallaufzeit des Korrektursignals 140 und einen Kombinierer 25 zum Überlagern des Ausgangssignals 102 und des Korrektursignals 140, um ein linearisiertes Ausgangssignal 402 zu erhalten.

Der Korrektursignalerzeuger 110 umfasst einen Koppler 41, der ausgelegt ist, um einen Teil des Nutzsignals (Eingangssignal) als analoges Referenzsignal 120 auszukoppeln. Die Signallaufzeit des analogen Referenzsignals 120 kann durch einen Verzögerer 42 an die Signallaufzeit des Ausgangssignals 102 des nicht-linearen Elements 10 angepasst werden und das analoge Referenzsignal 120 wird einem Kombinierer 43 zur Verfügung gestellt.

Nach dem Auskoppeln des analogen Referenzsignals 120 wird das Eingangssignal von einem Analog-Digital-Umsetzer 30 in ein digitales Signal umgewandelt und einem weiteren Koppler 11 zur Verfügung gestellt, der ausgelegt ist, um einen Teil des Eingangssignals als digitales Referenzsignal 130 auszukoppeln. Danach kann die Amplitude und die Phase des Eingangssignals von einem digitalen Amplitudensteller 44 und einem digitalen Phasensteller 45 so verändert, dass das resultierende Ausgangssignal 102 des nicht-linearen Elements 10 an das analoge Referenzsignal 120 angepasst ist. Danach wird das Eingangssignal von einem Digital-Analog-Umsetzer 31 in ein analoges Signal umgewandelt und dem nicht-linearen Element 10 zur Verfügung gestellt, das basierend auf dem Eingangssignal das Ausgangssignal 102 erzeugt.

Des Weiteren umfasst der Korrektursignalerzeuger 110 einen Koppler 12, der ausgelegt ist, um einen Teil des Ausgangssignals 102 des nicht-linearen Elements 10 auszukoppeln und dem Kombinierer 43 zur Verfügung zu stellen. Der Kombinierer 43 ist dabei ausgelegt, um das analoge Referenzsignal 120 mit dem Ausgangssignal 102 zu überlagern und das überlagerte Ausgangssignal nach einer Umwandlung in ein digitales Signal durch einen Analog-Digital-Umsetzer 32 einem weiteren Kombinierer 16 zur Verfügung zu stellen.

Das zuvor ausgekoppelte digitale Referenzsignal 130 wird durch einen digitalen Amplitudensteller 13, einen digitalen Phasensteller 14 und einen Verzögerer 15 an das überlagerte Ausgangssignal angepasst und dem Kombinierer 16 zur Verfügung gestellt. Der Kombinierer 16 ist ausgelegt, um das überlagerte Ausgangssignal und das digitale Referenzsignal 130 zu überlagern und das Korrektursignal 140 zu erzeugen.

Das Korrektursignal 140 kann danach beispielsweise durch einen weiteren digitalen Amplitudensteller 22 und einen weiteren digitalen Phasensteller 23 sowie nach Umwandlung in ein analoges Signal durch einen Digital-Analog-Umsetzer 33 von einem Hilfsverstärker 24 an das Ausgangssignal 102 des nicht-linearen Elements 10 angepasst werden. Die Elemente zum Anpassen des Korrektursignals 140 können alternativ auch Teil des Korrektursignalerzeugers 110 sein.

Es wird also beispielsweise das Ausgangssignal 102 des nicht-linearen Elements 10 nach dem Auskoppeln (durch den Koppler 12) mit dem durch den Koppler 41 ausgekoppelten Nutzsignal (analoge Referenzsignal) durch den Kombinierer 43 summiert. Amplitude und Phase können im Sendepfad (Pfad zwischen dem Koppler 41 und dem nicht-linearen Element 10) beispielsweise mit digitalen Stellgliedern (Amplitudensteller 44 und Phasensteller 45) abgeglichen werden, so dass am Summationspunkt (Kombinierer 43) die beiden Signale (das Ausgangssignal und das analoge Referenzsignal) eine möglichst gleiche Amplitude und möglichst einen 180 Grad Phasenversatz aufweisen. Die Laufzeit durch das nicht-lineare Element 10 kann durch eine Verzögerung (durch den Verzögerer 42) ausgeglichen werden.

Wegen dem Phasenversatz von 180 Grad wird im Kombinierer 43 der Nutzsignal-Anteil unterdrückt. Damit können beispielsweise die Anforderungen an die Dynamik des Analog-Digital-Umsetzers 32 entsprechend dem Maß der Unterdrückung in dem Kombinierer 43 gesenkt werden.

Die Nutzsignalunterdrückung ist somit einerseits durch die analoge Vorunterdrückung durch den Kombinierer 43 und durch die zweite Überlagerung durch den Kombinierer 16 realisiert. Die Fehlersignalunterdrückung kann später von dem Kombinierer 25 durchgeführt werden.

Des Weiteren ist in Fig. 4 der Bereich 310 der digitalen Signalverarbeitung markiert.

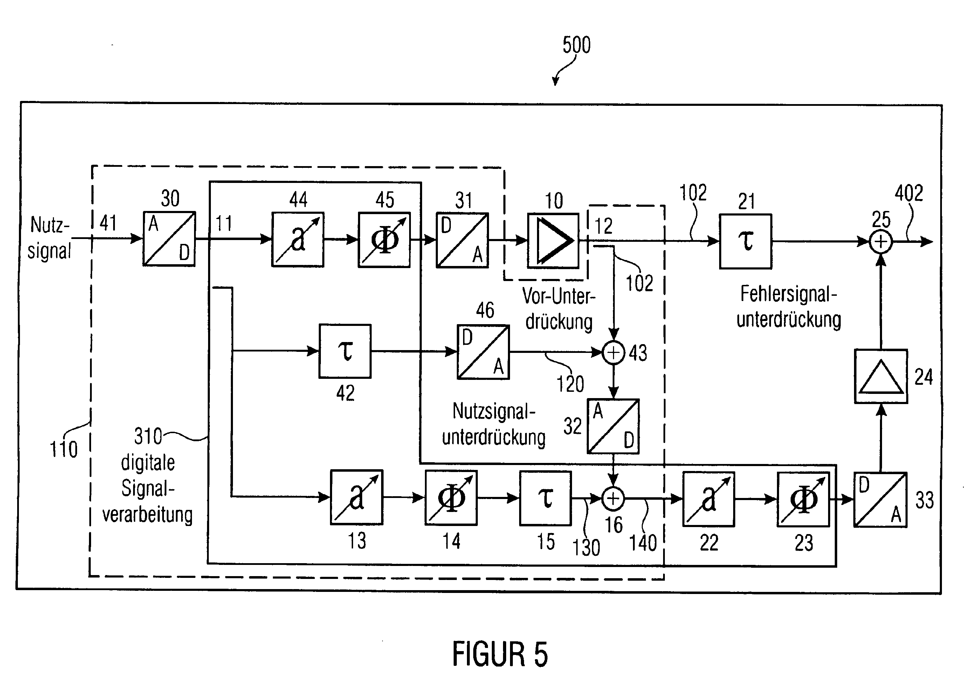

Fig. 5 zeigt ein Blockschaltbild einer weiteren Vorrichtung 500 zum Linearisieren eines Ausgangssignals 102 eines nicht-linearen Elements 10 entsprechend einem Ausführungsbeispiel gemäß der Erfindung. Die Vorrichtung entspricht dabei im Prinzip der in Fig. 4 gezeigten Vorrichtung. Jedoch wird das (analoge) Referenzsignal für die Vorunterdrückung statt durch einen eigenen Koppler 41 im Analogen im Digitalen vom Koppler 11 (ebenso wie das digitale Referenzsignal) abgenommen. In diesem Fall wird vor der Überlagerung oder Summation das (analoge) Referenzsignal mit einem Digital-Analog-Umsetzer 46 ins Analoge umgesetzt. Dann kann auch die Verzögerung (der Verzögerer 42) im Digitalen implementiert werden, und der Abgleich (mit dem Amplitudensteller 44 und dem Phasensteller 45) könnte statt im Sendepfad (Pfad, über den das Eingangssignal zum nicht-linearen Element gelangt) auch im Referenzpfad (Pfad, in dem das analoge Referenzsignal zum Kombinierer 43 gelangt) erfolgen.

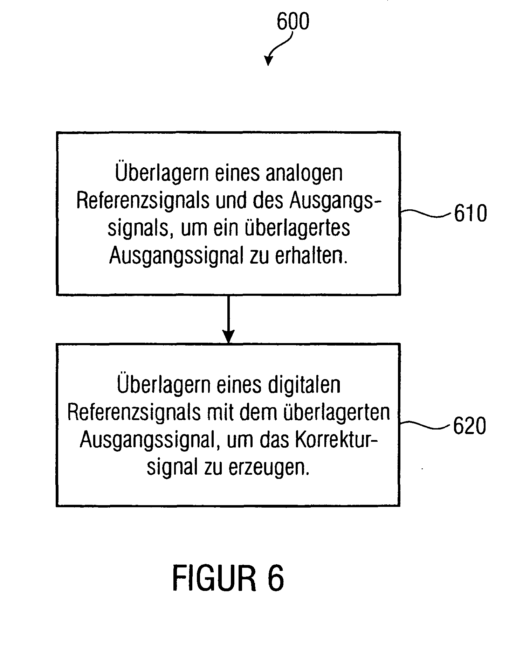

Fig. 6 zeigt ein Flussdiagramm eines Verfahrens 600 zum Erzeugen eines Korrektursignals zum Linearisieren eines Ausgangssignals eines nicht-linearen Elements entsprechend einem Ausführungsbeispiel gemäß der Erfindung. Das Verfahren 600 umfasst dabei ein Überlagen 610 eines analogen Referenzsignals und eines Ausgangssignals, um ein überlagertes Ausgangssignal zu erhalten, und ein Überlagern 620 eines digitalen Referenzsignals mit dem überlagerten Ausgangssignal, um das Korrektursignal zu erzeugen.

Einige Ausführungsbeispiele gemäß der Erfindung beziehen sich auf eine Vorrichtung, bei der die Anforderungen an Analog-Digital-Umsetzer durch eine analoge Vorunterdrückung des Nutzsignals (Eingangssignals) reduziert werden können, bei der der Abgleich im Digitalen oder alternativ im Analogen erfolgt.

Weitere Ausführungsbeispiele gemäß der Erfindung beziehen sich auf eine Vorrichtung zur Unterdrückung unerwünschter Signalanteile nach dem Feedforward-Prinzip, bei dem durch den Einsatz von Analog-Digital-Umsetzern und Digital-Analog-Umsetzern ein großer Teil der Funktionsblöcke, wie z.B. für den Abgleich, in digitaler Signalverarbeitung erfolgt.

Durch die Implementierung von Phasenstellern und Amplitudenstellern im Digitalen ist ein Abgleich der Schleifen genauer möglich als mit analogen Stellgliedern, und es kann somit die Abgleichgenauigkeit verbessert werden.

Nachteile analoger Stellglieder, wie beispielsweise eine nicht konstante Gruppenlaufzeit und Nicht-Linearitäten können vermieden werden.

Neben den Stellgliedern können weitere Komponenten in der digitalen Signalverarbeitung implementiert werden, die die Systemeigenschaften und die Funktionalität verbessern können. Dazu gehören beispielsweise digitale Filter, mit denen der Frequenzgang der Schleifen entzerrt werden kann.

Zusätzlich ist die Implementierung von digitalen Stellgliedern mit deutlich weniger Aufwand verbunden als der Aufbau von analogen Stellgliedern und ihre Ansteuerung.

Eine Implementierung im Digitalen ist einfach rekonfigurierbar und erlaubt damit eine Flexibilität, die mit analogen Komponenten nicht erreichbar ist.

In der vorliegenden Anmeldung werden teilweise für Objekte und Funktionseinheiten, die gleiche oder ähnliche funktionelle Eigenschaften aufweisen, gleiche Bezugszeichen verwendet.

Der Begriff Ausgangssignal des nicht-linearen Elements wird sowohl für das direkte Ausgangssignal des nicht-linearen Elements als auch beispielsweise für einen ausgekoppelten Teil des Ausgangssignal, der mit dem analogen Referenzsignal überlagert wird, verwendet.

Das beschriebene Prinzip ist unabhängig von der Art des nicht-linearen Elements. Beispielsweise können die Komponenten der Vorrichtung den jeweiligen Anforderungen, wie z.B. dem Frequenzbereich, angepasst werden.

Insbesondere wird darauf hingewiesen, dass abhängig von den Gegebenheiten, das erfindungsgemäße Schema auch in Software implementiert sein kann. Die Implementation kann auf einem digitalen Speichermedium, insbesondere einer Diskette oder einer CD mit elektronisch auslesbaren Steuersignalen erfolgen, die so mit einem programmierbaren Computersystem zusammenwirken können, dass das entsprechende Verfahren ausgeführt wird. Allgemein besteht die Erfindung somit auch in einem Computerprogrammprodukt mit auf einem maschinenlesbaren Träger gespeicherten Programmcode zur Durchführung des erfindungsgemäßen Verfahrens, wenn das Computerprogrammprodukt auf einem Rechner abläuft. In anderen Worten ausgedrückt, kann die Erfindung somit als ein Computerprogramm mit einem Programmcode zur Durchführung des Verfahrens realisiert werden, wenn das Computerprogrammprodukt auf einem Computer abläuft.

## Patentansprüche

1. Vorrichtung (100) zum Erzeugen eines Korrektursignals zum Linearisieren eines Ausgangssignals eines nicht-linearen Elements mit folgendem Merkmal:
einem Korrektursignalerzeuger (110), der ausgelegt ist, um basierend auf einer Überlagerung eines digitalen Referenzsignals (130) und eines überlagerten Ausgangssignals ein Korrektursignal (140) zu erzeugen, wobei das überlagerte Ausgangssignal auf einer Überlagerung des Ausgangssignals (102) und eines analogen Referenzsignals (120) basiert,
wobei das nicht-lineare Element ausgelegt ist, um das Ausgangssignal (102) basierend auf einem Eingangssignal zu erzeugen, und
wobei das digitale Referenzsignal (130) und das analoge Referenzsignal (120) auf dem Eingangssignal basieren.

2. Vorrichtung zum Erzeugen eines Korrektursignals gemäß Anspruch 1, die einen Analog-Digital-Umsetzer aufweist, wobei der Analog-Digital-Umsetzer ausgelegt ist, um das überlagerte Ausgangssignal in ein digitales Signal umzuwandeln.

3. Vorrichtung zum Erzeugen eines Korrektursignals gemäß Anspruch 1 oder 2, die einen ersten Kombinierer und einen zweiten Kombinierer aufweist, wobei der erste Kombinierer ausgelegt ist, um das analoge Referenzsignal (120) mit dem Ausgangssignal (102) zu überlagern, um das überlagerte Ausgangssignal zu erhalten, und wobei der zweite Kombinierer ausgelegt ist, um das digitale Referenzsignal (130) mit dem überlagerten Ausgangssignal zu überlagern, um das Korrektursignal (140) zu erhalten.

4. Vorrichtung zum Erzeugen eines Korrektursignals gemäß einem der Ansprüche 1 bis 3, mit folgenden weiteren Merkmalen:
einem digitalen Amplitudensteller, der ausgelegt ist, um eine Amplitude des digitalen Referenzsignals (130) an eine Amplitude des überlagerten Ausgangssignals anzupassen;
einem digitalen Phasensteller, der ausgelegt ist, um eine Phase des digitalen Referenzsignals (130) an eine Phase des überlagerten Ausgangssignals anzupassen; und
einen digitalen Verzögerer, der ausgelegt ist, um eine Signallaufzeit des digitalen Referenzsignals (130) an eine Signallaufzeit des überlagerten Ausgangssignals anzupassen.

5. Vorrichtung zum Erzeugen eines Korrektursignals gemäß einem der Ansprüche 1 bis 4, die einen weiteren digitalen Amplitudensteller und einen weiteren digitalen Phasensteller aufweist, wobei der weitere digitale Amplitudensteller ausgelegt ist, um eine Amplitude des Eingangssignals, und dadurch eine Amplitude des Ausgangssignals (102), an eine Amplitude des analogen Referenzsignals (120) anzupassen, und wobei der weitere digitale Phasensteller ausgelegt ist, um eine Phase des Eingangssignals, und dadurch eine Phase des Ausgangssignals (102), an eine Phase des analogen Referenzsignals (120) anzupassen.

6. Vorrichtung zum Erzeugen eines Korrektursignals gemäß einem der Ansprüche 1 bis 5, die einen Koppler und einen Digital-Analog-Umsetzer aufweist, wobei der Koppler ausgelegt ist, um einen Teil des Eingangssignals auszukoppeln und als digitales Referenzsignal (130) bereitzustellen, und wobei der Digital-Analog-Umsetzer ausgelegt ist, um basierend auf dem digitalen Referenzsignal (130) das analoge Referenzsignal (120) zu erzeugen.

7. Vorrichtung zum Erzeugen eines Korrektursignals gemäß Anspruch 6, die einen digitalen Verzögerer aufweist, wobei der digitale Verzögerer ausgelegt ist, um eine Signallaufzeit des analogen Referenzsignals (120) an eine Signallaufzeit des Ausgangssignals (102) anzupassen.

8. Vorrichtung zum Erzeugen eines Korrektursignals gemäß einem der Ansprüche 1 bis 5, die einen ersten Koppler und einen zweiten Koppler aufweist, wobei der erste Koppler ausgelegt ist, um einen Teil des Eingangssignals auszukoppeln und als analoges Referenzsignal (120) bereitzustellen, wobei der zweite Koppler ausgelegt ist, um einen Teil des Eingangssignals auszukoppeln und als digitales Referenzsignal (130) bereitzustellen, wobei das Eingangssignal zwischen dem ersten Koppler und dem zweiten Koppler von einem Analog-Digital-Umsetzer von einem analogen Signal in ein digitales Signal umgewandelt wird.

9. Vorrichtung zum Erzeugen eines Korrektursignals gemäß Anspruch 8, die einen analogen Verzögerer aufweist, wobei der analoge Verzögerer ausgelegt ist, um eine Signallaufzeit des analogen Referenzsignals (120) an eine Signallaufzeit des Ausgangssignals (102) anzupassen.

10. Vorrichtung (400, 500) zum Linearisieren eines Ausgangssignals eines nicht-linearen Elements mit einer Vorrichtung zum Erzeugen eines Korrektursignals gemäß einem der Ansprüche 1 bis 9, mit folgendem Merkmal:
einem Ausgangssignalkombinierer, der ausgelegt ist, um das Ausgangssignal (102) mit dem Korrektursignal (140) zu überlagern, um das Ausgangssignal (102) zu linearisieren.

11. Vorrichtung zum Linearisieren eines Ausgangssignals eines nicht-linearen Elements gemäß Anspruch 10, die einen Verzögerer aufweist, der ausgelegt ist, um eine Signallaufzeit des Ausgangssignals (102) an eine Signallaufzeit des Korrektursignals (140) anzupassen.

12. Vorrichtung zum Linearisieren eines Ausgangssignals eines nicht-linearen Elements gemäß Anspruch 10 oder 11, mit folgenden weiteren Merkmalen:
einem digitalen Amplitudensteller, der ausgelegt ist, um eine Amplitude des Korrektursignals (140) an eine Amplitude des Ausgangssignals (102) anzupassen;
einem digitalen Phasensteller, der ausgelegt ist, um eine Phase des Korrektursignals (140) an eine Phase des Ausgangssignals (102) anzupassen;
einem Verstärker, der ausgelegt ist, um das Korrektursignal (140) an das Ausgangssignal (102) anzupassen.

13. Verfahren (600) zum Erzeugen eines Korrektursignals zum Linearisieren eines Ausgangssignals eines nicht-linearen Elements mit folgenden Schritten:
Überlagern (610) eines analogen Referenzsignals und des Ausgangssignals, um ein überlagertes Ausgangssignal zu erhalten; und
Überlagern (620) eines digitalen Referenzsignals mit dem überlagerten Ausgangssignal, um das Korrektursignal zu erzeugen,
wobei das nicht-lineare Element ausgelegt ist, um das Ausgangssignal (102) basierend auf einem Eingangssignal zu erzeugen, und
wobei das digitale Referenzsignal (130) und das analoge Referenzsignal (120) auf dem Eingangssignal basieren.

14. Verfahren zum Linearisieren eines Ausgangssignals eines nicht-linearen Elements mit folgenden Schritten:
Erzeugen eines Korrektursignals gemäß dem Verfahren in Anspruch 13;
Überlagern des Korrektursignals mit dem Ausgangssignal, um ein linearisiertes Ausgangssignal zu erzeugen,

15. Computerprogramm mit einem Programmcode zur Durchführung des Verfahrens nach Anspruch 13 oder 14, wenn das Computerprogramm auf einem Computer oder Mikrocontroller abläuft.

## Claims

1. An apparatus (100) for generating a correction signal for linearizing an output signal of a non-linear element, comprising:
a correction signal generator (110) configured to generate a correction signal (140) on the basis of a superposition of a digital reference signal (130) and a superposed output signal, the superposed output signal being based on a superposition of the output signal (102) and an analog reference signal (120),
wherein the non-linear element is configured to generate the output signal (102) on the basis of an input signal, and
wherein the digital reference signal (130) and the analog reference signal (120) are based on the input signal.

2. The apparatus for generating a correction signal as claimed in claim 1, comprising an analog-to-digital converter, the analog-to-digital converter being configured to convert the superposed output signal to a digital signal.

3. The apparatus for generating a correction signal as claimed in any of claims 1 or 2, comprising a first combiner and a second combiner, the first combiner being configured to superpose the analog reference signal (120) with the output signal (102) so as to obtain the superposed output signal, and the second combiner being configured to superpose the digital reference signal (130) with the superposed output signal so as to obtain the correction signal (140).

4. The apparatus for generating a correction signal as claimed in any of claims 1 to 3, further comprising:
a digital amplitude adjuster configured to adapt an amplitude of the digital reference signal (130) to an amplitude of the superposed output signal;
a digital phase shifter configured to adapt a phase of the digital reference signal (130) to a phase of the superposed output signal; and
a digital delayer configured to adapt a signal delay time of the digital reference signal (130) to a signal delay time of the superposed output signal.

5. The apparatus for generating a correction signal as claimed in any of claims 1 to 4, comprising a further digital amplitude adjuster and a further digital phase shifter, the further digital amplitude adjuster being configured to adapt an amplitude of the input signal and, thus, an amplitude of the output signal (102) to an amplitude of the analog reference signal (120), and the further digital phase shifter being configured to adapt a phase of the input signal and, thus, a phase of the output signal (102) to a phase of the analog reference signal (120).

6. The apparatus for generating a correction signal as claimed in any of claims 1 to 5, comprising a coupler and a digital-to-analog converter, the coupler being configured to couple out part of the input signal and to provide it as the digital reference signal (130), and the digital-to-analog converter being configured to generate the analog reference signal (120) on the basis of the digital reference signal (130).

7. The apparatus for generating a correction signal as claimed in claim 6, comprising a digital delayer, the digital delayer being configured to adapt a signal delay time of the analog reference signal (120) to a signal delay time of the output signal (102).

8. The apparatus for generating a correction signal as claimed in any of claims 1 to 5, comprising a first coupler and a second coupler, the first coupler being configured to couple out part of the input signal and to provide it as the analog reference signal (120), the second coupler being configured to couple out part of the input signal and to provide it as the digital reference signal (130), the input signal between the first coupler and the second coupler being converted from an analog signal to a digital signal by an analog-to-digital converter.

9. The apparatus for generating a correction signal as claimed in claim 8, comprising an analog delayer, the analog delayer being configured to adapt a signal delay time of the analog reference signal (120) to a signal delay time of the output signal (102).

10. An apparatus (400, 500) for linearizing an output signal of a non-linear element with an apparatus for generating a correction signal as claimed in any of claims 1 to 9, comprising:
an output signal combiner configured to superpose the output signal (102) with the correction signal (140) so as to linearize the output signal (102).

11. The apparatus for linearizing an output signal of a non-linear element as claimed in claim 10, comprising a delayer configured to adapt a signal delay time of the output signal (102) to a signal delay time of the correction signal (140).

12. The apparatus for linearizing an output signal of a non-linear element as claimed in claims 10 or 11, further comprising:
a digital amplitude adjuster configured to adapt an amplitude of the correction signal (140) to an amplitude of the output signal (102);
a digital phase shifter configured to adapt a phase of the correction signal (140) to a phase of the output signal (102);
an amplifier configured to adapt the correction signal (140) to the output signal (102).

13. A method (600) for generating a correction signal for linearizing an output signal of a non-linear element, comprising:
superposing (610) an analog reference signal and the output signal so as to obtain a superposed output signal; and
superposing (620) a digital reference signal with the superposed output signal so as to generate the correction signal,
wherein the non-linear element is configured to generate the output signal (102) on the basis of an input signal, and
wherein the digital reference signal (130) and the analog reference signal (120) are based on the input signal.

14. A method for linearizing an output signal of a non-linear element, comprising:
generating a correction signal according to the method as claimed in claim 13;
superposing the correction signal with the output signal so as to generate a linearized output signal,

15. A computer program comprising a program code for performing the method as claimed in claims 13 or 14, when the computer program runs on a computer or microcontroller.

## Revendications

1. Dispositif (100) pour générer un signal de correction pour linéariser un signal de sortie d'un élément non linéaire, avec la caractéristique suivante:
un générateur de signal de correction (110) qui est conçu pour générer, sur base d'une superposition d'un signal numérique de référence (130) et d'un signal de sortie superposé, un signal de correction (140), le signal de sortie superposé étant basé sur une superposition du signal de sortie (102) et d'un signal analogique de référence (120),
dans lequel l'élément non linéaire est conçu pour générer le signal de sortie (102) sur base d'un signal d'entrée, et
dans lequel le signal numérique de référence (130) et le signal analogique de référence (120) sont basés sur le signal d'entrée.

2. Dispositif pour générer un signal de correction selon la revendication 1, présentant un convertisseur analogique-numérique, ledit convertisseur analogique-numérique étant conçu pour convertir le signal de sortie superposé en un signal numérique.

3. Dispositif pour générer un signal de correction selon la revendication 1 ou 2, présentant un premier combineur et un deuxième combineur, le premier combineur étant conçu pour superposer le signal analogique de référence (120) avec le signal de sortie (102), pour obtenir le signal de sortie superposé, et le deuxième combineur étant conçu pour superposer le signal numérique de référence (130) avec le signal de sortie superposé, pour obtenir le signal de correction (140).

4. Dispositif pour générer un signal de correction selon l'une des revendications 1 à 3, avec les autres caractéristiques suivantes:
un régulateur d'amplitude numérique qui est conçu pour adapter une amplitude du signal numérique de référence (130) à une amplitude du signal de sortie superposé;
un régulateur de phase numérique qui est conçu pour adapter une phase du signal numérique de référence (130) à une phase du signal de sortie superposé; et
un temporisateur numérique qui est conçu pour adapter un temps de propagation du signal numérique de référence (130) à un temps de propagation du signal de sortie superposé.

5. Dispositif pour générer un signal de correction selon l'une des revendications 1 à 4, présentant un autre régulateur d'amplitude numérique et un autre régulateur de phase numérique, l'autre régulateur d'amplitude numérique étant conçu pour adapter une amplitude du signal d'entrée, et de ce fait une amplitude du signal de sortie (102), à une amplitude du signal analogique de référence (120), et l'autre régulateur de phase numérique étant conçu pour adapter une phase du signal d'entrée, et de ce fait une phase du signal de sortie (102), à une phase du signal analogique de référence (120).

6. Dispositif pour générer un signal de correction selon l'une des revendications 1 à 5, présentant un coupleur et un convertisseur numérique-analogique, le coupleur étant conçu pour découpler une partie du signal d'entrée et pour la mettre à disposition comme signal numérique de référence (130), et le convertisseur numérique-analogique étant conçu pour générer, sur base du signal numérique de référence (130), le signal analogique de référence (120).

7. Dispositif pour générer un signal de correction selon la revendication 6, présentant un temporisateur numérique, le temporisateur numérique étant conçu pour adapter un temps de propagation du signal analogique de référence (120) à un temps de propagation du signal de sortie (102).

8. Dispositif pour générer un signal de correction selon l'une des revendications 1 à 5, présentant un premier coupleur et un deuxième coupleur, le premier coupleur étant conçu pour découpler une partie du signal d'entrée et pour le mettre à disposition comme signal analogique de référence (120), le deuxième coupleur étant conçu pour découpler une partie du signal d'entrée et pour la mettre à disposition comme signal numérique de référence (130), le signal d'entrée étant converti entre le premier coupleur et le deuxième coupleur par un convertisseur analogique-numérique d'un signal analogique en un signal numérique.

9. Dispositif pour générer un signal de correction selon la revendication 8, présentant un temporisateur analogique, le temporisateur étant conçu pour adapter un temps de propagation du signal de référence analogique (120) à un temps de propagation du signal de sortie (102).

10. Dispositif (400, 500) pour linéariser un signal de sortie d'un élément non linéaire avec un dispositif pour générer un signal de correction selon l'une des revendications 1 à 9, avec la caractéristique suivante:
un combineur de signal de sortie qui est conçu pour superposer le signal de sortie (102) avec le signal de correction (140), pour linéariser le signal de sortie (102).

11. Dispositif pour linéariser un signal de sortie d'un élément non linéaire selon la revendication 10, qui présente un temporisateur qui est conçu pour adapter un temps de propagation du signal de sortie (102) à un temps de propagation du signal de correction (140).

12. Dispositif pour linéariser un signal de sortie d'un élément non linéaire selon la revendication 10 ou 11, avec les autres caractéristiques suivantes:
un régulateur d'amplitude numérique qui est conçu pour adapter une amplitude du signal de correction (140) à une amplitude du signal de sortie (102);
un régulateur de phase numérique qui est conçu pour adapter une phase du signal de correction (140) à une phase du signal de sortie (102);
un amplificateur qui est conçu pour adapter le signal de correction (140) au signal de sortie (102).

13. Procédé (600) pour générer un signal de correction pour linéariser un signal de sortie d'un élément non linéaire, aux étapes suivantes consistant à:
superposer (610) un signal analogique de référence et le signal de sortie, pour obtenir un signal de sortie superposé; et
superposer (620) un signal numérique de référence avec le signal de sortie superposé, pour générer le signal de correction,
dans lequel l'élément non linéaire est conçu pour générer le signal de sortie (102) sur base d'un signal d'entrée, et
dans lequel le signal numérique de référence (130) et le signal analogique de référence (120) sont basés sur le signal d'entrée.

14. Procédé pour linéariser un signal de sortie d'un élément non linéaire aux étapes suivantes consistant à:
générer un signal de correction selon le procédé de la revendication 13;
superposer le signal de correction avec le signal de sortie, pour générer un signal de sortie linéarisé.

15. Programme d'ordinateur avec un code de programme pour réaliser le procédé selon la revendication 13 ou 14 lorsque le programme d'ordinateur est exécuté sur un ordinateur ou un microcontrôleur.
